# FASCICULE DE BREVET EUROPEEN

(11) **EP 1 428 258 B1**
(45) Date de publication et mention de la délivrance du brevet: **30.08.2017**
(21) Numéro de dépôt: 02772644.7
(22) Date de dépôt: 17.09.2002
(51) Int. Cl.: H01L 23/498, G06K 19/077

(54) **PROCEDE DE FABRICATION D'UNE ETIQUETTE ELECTRONIQUE DE FAIBLE EPAISSEUR**
HERSTELLUNG EINES ELEKTRONISCHEN ETIKETTES GERINGER DICKE
METHOD FOR MAKING A THIN ELECTRONIC TAG

(30) Priorité: 18.09.2001 CH 171801
(43) Date de publication de la demande: 16.06.2004
(73) Titulaire: Nagravision S.A., 1033 Cheseaux-sur-Lausanne (CH)
(72) Inventeur: DROZ, François, 2300 La Chaux-de-Fonds (CH)
(74) Mandataire: Wenger, Joel-Théophile
(86) Numéro de dépôt international: PCT/IB2002/003953
(87) Numéro de publication internationale: WO 2003/026010

(56) Documents cités:
- EP-A- 0 307 773
- EP-A- 0 514 637
- EP-A- 0 734 063
- WO-A-01/26910
- WO-A1-95/21423
- DE-A- 3 019 207

## Description

La présente invention concerne un procédé de fabrication d'une carte ou une étiquette électronique de faible épaisseur comprenant au moins un composant électronique.

Le procédé permet de fabriquer une carte avec ou sans contact extérieur ou une étiquette électronique. On entend par étiquette électronique, un ensemble comprenant au moins un support, une antenne et un composant électronique, en général une puce. La carte ou l'étiquette électronique obtenue par le procédé se trouve dans de nombreuses applications comme moyen d'identification, de contrôle ou de paiement.

Le procédé de la présente invention permet d'obtenir des cartes ou des étiquettes souples de faible épaisseur dans lesquelles au moins un composant électronique est monté. Un composant électronique est un élément tel que: une puce, une capacité, une résistance, un fusible, une batterie, un affichage, un contrôleur d'empreintes digitales ("fingertip") ou tout autre élément similaire.

Il est connu de l'homme du métier des cartes ou des étiquettes où des composants sont montés sur un support isolant, appelé substrat, sur lequel sont gravées des pistes et des plages de connexion en matériau conducteur (cuivre en général). Les composants sont en général collés, puis leurs contacts sont soudés sur les pistes ou sur les plages de connexion conductrices du substrat. Afin de protéger les composants et le circuit ainsi câblé, une résine époxy est coulée sur toute ou partie de la surface pour enrober l'ensemble du circuit.

Le document EP1167068 décrit une connexion par pressage des contacts d'une puce dans les pistes gravées sur un substrat et provenant d'une antenne en forme de bobine. La connexion de la puce s'effectue sans soudure grâce à des pointes ajoutées préalablement sur les contacts et destinées à s'enfoncer dans le métal de la piste conductrice. L'ensemble est ensuite enrobé dans la résine et/ou recouvert d'une couche isolante.

Le document WO95/521423A1 décrit une carte à puce multicouches et un procédé de fabrication de cette carte. Un module électronique avec des contacts disposés sur une de ses faces est placé dans une fenêtre formée dans un substrat isolant de sorte que la face munie des contacts affleure la surface de la carte. Ce module électronique est un composant pré-assemblé formé de plusieurs éléments notamment d'une puce connectée à des surfaces de contact destinées à être visibles sur la surface de la carte.

Ces deux types de cartes ou d'étiquettes électroniques connus décrits ci-dessus présentent l'inconvénient d'avoir d'une part une épaisseur élevée et difficilement contrôlable au cours de leur fabrication et d'autre part une souplesse limitée. En effet, les composants sont de hauteur inégale et l'épaisseur de l'enrobage doit correspondre à la hauteur maximale atteinte par au moins un des composants afin d'assurer une planéité acceptable de la carte. Pour information, l'épaisseur d'une carte standard, définie selon la norme ISO 7816, est de 0.76 mm.

Dans le second cas où les contacts des composants sont implantés par pressage dans les conducteurs gravés dans le substrat, la qualité de la liaison contact-conducteur varie selon les contraintes mécaniques subies par la carte comme la flexion ou la torsion.

Le but de la présente invention est de pallier les inconvénients décrits ci-dessus à savoir d'obtenir une carte ou une étiquette plane, souple et de faible épaisseur avec un taux de déchet à la fabrication minimal. Ceci concerne en particulier la qualité de la liaison électrique entre le ou les composants électroniques et les pistes de la partie conductrice de la carte.

Ce but est atteint par un procédé de fabrication d'une une carte ou étiquette électronique réalisée par assemblage d'au moins un substrat souple de faible épaisseur, une couche conductrice et une couche adhésive, et comprenant au moins un composant électronique, ladite couche conductrice étant constituée de pistes conductrices définissant une antenne. Le substrat comprend au moins une fenêtre dans laquelle est logé le composant électronique, la couche adhésive maintient la couche conductrice sur le substrat, la couche conductrice s'étend partiellement dans la surface de la fenêtre de sorte à former au moins un contact électrique sur lequel est connecté le composant électronique.

La carte ou l'étiquette électronique obtenue par le procédé selon l'invention est constituée d'une couche isolante appelée substrat, d'épaisseur choisie de préférence en fonction de la hauteur la plus élevée du composant à monter. L'épaisseur choisie pour le substrat va déterminer l'aspect final, à savoir si le composant va affleurer la surface de la carte, former un relief ou un creux sur la carte.

Ce substrat comporte des fenêtres qui servent de logement aux composants électroniques. Les dimensions de ces fenêtres sont déterminées selon celles du composant et de l'espace nécessaire autour de celui-ci. Selon une première réalisation, l'espace autour du composant est minimal afin de maintenir temporairement le composant électronique dans son logement avant la phase de soudage.

Selon une autre réalisation, l'espace est plus généreux de sorte à pouvoir le remplir de liant ou accueillir plus d'un composant.

Les contacts du composant sont reliés à des pistes conductrices gravées sur au moins une face du substrat. Ces contacts sont reliés soit par connexion directe sur les pistes conductrices, c'est-à-dire sur le prolongement de la couche conductrice dans la fenêtre, soit par l'intermédiaire d'un pont conducteur. Plusieurs configurations peuvent se présenter:
- les deux contacts du composant sont reliés à la couche conductrice par connexion directe sur les pistes conductrices,
- un contact est relié à la couche conductrice par connexion directe alors que l'autre contact du composant est relié à une plage de connexion plus éloignée sur la couche conductrice par un pont conducteur isolé passant par-dessus d'autres pistes,
- le pont conducteur connecté à un contact du composant passe à côté du composant dans la fenêtre du substrat où est logé ledit composant pour se trouver sur la face opposée du substrat. Le pont se connecte sur la face conductrice en traversant le substrat selon une méthode connue de l'homme de métier. L'autre contact du composant est relié à la couche conductrice par connexion directe ou par l'intermédiaire d'un autre pont comme décrit plus haut.

Une carte ou une étiquette électronique ainsi formée possède une épaisseur qui correspond à la hauteur maximale mesurée dans le lot des composants utilisés à laquelle il faut ajouter l'épaisseur de la couche conductrice. Sa souplesse est d'autant plus grande que son épaisseur est faible. Les composants montés sont noyés dans l'épaisseur du substrat et ainsi protégés des agressions mécaniques.

Le procédé de fabrication de cartes ou d'étiquettes électroniques réalisées par assemblage d'au moins un substrat souple de faible épaisseur, une couche conductrice et une couche adhésive, et comprenant au moins un composant électronique, comporte les étapes décrites par la revendication 1 à effectuer par ordre chronologique.

Le segment formé dans la couche conductrice est une ouverture pratiquée en général par étampage ou par gravure chimique dans la couche conductrice. Cette ouverture a une forme et des dimensions qui dépendent de la configuration des contacts du composant électronique. Elle sert à créer une surface de connexion pour ces contacts lors de la réalisation du circuit électrique.

Il résulte des caractéristiques décrites ci-dessus un procédé de fabrication d'une carte ou d'une étiquette électronique comprenant au moins un composant électronique, selon l'invention, nécessitant un nombre réduit d'opérations et qui, de plus, sont peu coûteuses. Ce procédé assure les propriétés exigées pour une telle carte ou étiquette: faible épaisseur, grande souplesse, fiabilité élevée par la bonne tenue des contacts des composants électroniques.

La taille de la fenêtre dans la couche adhésive est déterminée de telle sorte à enlever la colle dans la zone où le composant électronique sera monté sans pour autant enlever la colle sous les pistes conductrices. Cette définition laisse un grand choix de forme pour le moyen de formation de la couche adhésive.

Selon une autre variante du procédé de fabrication de la carte ou de l'étiquette selon l'invention, il est prévu de ne pas découper les fenêtres dans la couche de colle. En effet, ces fenêtres peuvent être formées par élimination de la colle résiduelle se trouvant sur les surfaces réservées aux contacts des composants, lesdites surfaces apparaissant dans les fenêtres découpées dans le substrat, la colle peut être éliminée par:
- des moyens chimiques avant la mise en place des composants électroniques
- évaporation ou refoulement lors de la connexion du composant électronique (soudage, thermo-collage ou thermo-compression).

Selon une autre variante du procédé de fabrication de la carte ou de l'étiquette selon l'invention, il est prévu de remplacer le film de colle utilisé pour constituer la couche adhésive par une colle liquide déposée sur la couche conductrice par sérigraphie avec des épargnes pour former les fenêtres qui empêchent le dépôt de colle sur les surfaces réservées aux contacts des composants.

Selon une autre variante du procédé de fabrication de la carte ou de l'étiquette selon l'invention, il est prévu de déposer la couche adhésive sur le substrat par sérigraphie avec des zones épargnées pour former les fenêtres. La couche adhésive peut être également déposée sur toute la surface du substrat, (sans les épargnes), avant la découpe des fenêtres. L'étape de la formation des fenêtres dans le substrat permettant également d'éliminer la colle dans cette zone. La couche conductrice est assemblée ensuite sur le substrat, ce qui laisse les surfaces de contact de la couche conductrice réservées à la connexion des composants exemptes de colle.

Une des particularités de l'invention est que la partie de connexion du composant électronique ne vient pas en surépaisseur de la couche conductrice et du substrat, ce qui est généralement le cas selon les exemples de l'état de la technique.

L'invention sera mieux comprise grâce à la description détaillée qui va suivre et qui se réfère aux dessins annexés qui sont donnés à titre d'exemple nullement limitatif, dans lesquels:
- la figure 1 représente un film de colle avec des découpes de fenêtres,
- la figure 2 représente un ensemble constitué par le film de colle superposé à un film de matériau conducteur,
- la figure 3 représente l'ensemble constitué par le film de colle et le film conducteur avec des découpes de segments,
- la figure 4 représente un substrat avec des découpes de fenêtres
- la figure 5 représente la superposition du substrat sur l'ensemble film de colle film conducteur,
- la figure 6 représente une coupe de la carte ou de l'étiquette avec un composant électronique monté.
- la figure 7 représente une coupe de la carte ou de l'étiquette avec un composant électronique dont un contact est relié à la couche conductrice par un pont.
- la figure 8 représente une coupe de la carte ou de l'étiquette avec un composant électronique dont un contact est relié à la couche conductrice par un pont en passant par la face opposée du substrat.

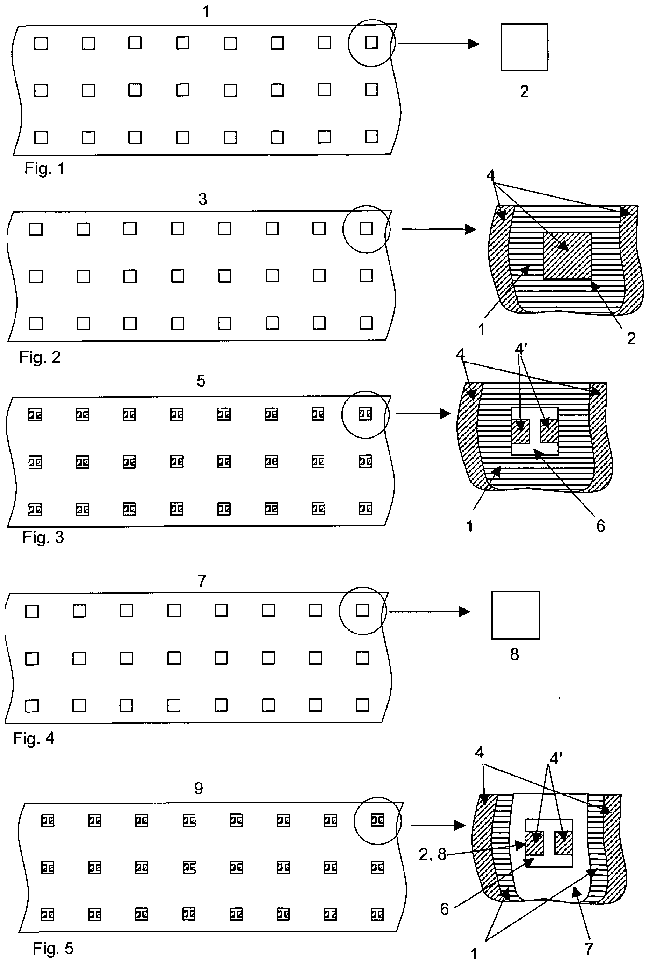

Les figures 1 à 6 illustrent les détails du procédé de fabrication d'une carte ou d'une étiquette électronique, selon l'invention, avec les résultats obtenus après chaque étape du procédé.

La figure 1 montre la découpe de fenêtres (2) dans un film de colle (1) effectuée par étampage par exemple. La forme et les dimensions des fenêtres dépendent des composants électroniques à monter par la suite. Ce film de colle constitue la couche adhésive.

Le film de colle découpé (1) est superposé et assemblé sur un film de matériau conducteur (4) pour constituer l'ensemble (3) couche adhésive et couche conductrice illustré par la figure 2. Le matériau conducteur est en général du cuivre. Celui-ci apparaît donc dans les fenêtres (2) de l'ensemble (3).

L'étape suivante est la découpe par étampage ou gravure chimique de segments (6) dans les fenêtres (2) de l'ensemble (3) couche adhésive et couche conductrice ce qui permet de préparer des surfaces de contacts séparées (4') pour les composants électroniques. On obtient ainsi l'ensemble (5). La forme de cette découpe a pour but de créer une séparation entre deux zones de matériau conducteur qui sont encore électriquement reliées par le plan conducteur environnant.

La figure 4 montre un substrat de matériau isolant (7) dont l'épaisseur est choisie en fonction de la hauteur maximale des composants électroniques à monter. Dans ce substrat, on découpe des fenêtres (8) de forme et de dimensions correspondant à ceux des composants. Ces fenêtres sont en général équivalentes à celles découpées dans le film de colle de la figure 1.

Le substrat (7) ainsi découpé est superposé et assemblé sur l'ensemble (3) couche adhésive et couche conductrice de façon à faire correspondre les fenêtres (8) du substrat avec les fenêtres (2) de l'ensemble couche adhésive et couche conductrice. Le résultat obtenu constitue un ensemble (9) substrat, couche adhésive et couche conductrice qui est représenté par la figure 5. Une vue agrandie de la face substrat montre les fenêtres (2) et (8) superposées à travers lesquelles on distingue les surfaces de contact conductrices (4') réservées au composant à monter.

Une étape, non illustrée, est la gravure d'un circuit sur la face conductrice (verso de l'ensemble (9) précédemment constitué) formé d'une pluralité de pistes dont la disposition dépend des composants électroniques et de leurs contacts. La méthode de gravure adoptée, étampage, usinage ou gravure chimique dépend essentiellement de la configuration du circuit et des matériaux utilisés pour le substrat et/ou pour le film conducteur.

Le composant est ensuite logé dans la fenêtre du substrat (8) prévue à cet effet puis connecté par exemple par soudage, collage à froid ou à chaud aux surfaces de contact (4').

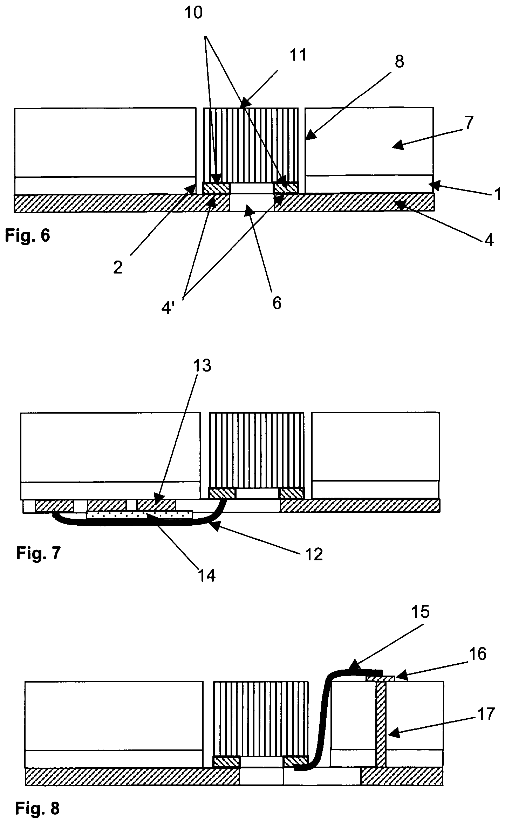

Le résultat final est montré par la coupe agrandie de la figure 6 ou l'on distingue la couche conductrice constituée par le film conducteur (4) assemblé sur le substrat (7) avec le film de colle (1) qui constitue la couche adhésive. Le composant (11) est logé dans la fenêtre (2) du film de colle (1) superposée à la fenêtre (8) du substrat (7), les contacts (10) dudit composant sont connectés aux surfaces conductrices (4') séparées par le segment (6).

La figure 7 illustre un pont électrique (12) qui relie un contact du composant électronique (11) à une piste éloignée sur la couche conductrice (4). Ce pont passe par-dessus d'autres pistes (13) et il est isolé électriquement de celles-ci par une épargne (14). Cette épargne est généralement constituée par un morceau de film mince en matière isolante. L'autre contact du composant est connecté directement sur la couche conductrice comme dans la figure 6.

La figure 8 illustre un pont électrique (15) qui relie un contact du composant électronique (11) en passant à côté de celui-ci à travers le substrat. Ce pont est ensuite connecté à une plage de connexion (16) située sur la face opposée du substrat, ladite plage est formée par un élément conducteur (17) traversant le substrat. Cet élément (17) est connecté à la couche conductrice (4).

Une dernière étape optionnelle, non illustrée, de la fabrication de la carte ou de l'étiquette consiste à assembler un film de matière isolante sur chacune des faces afin de protéger l'assemblage, illustré par la figure 6, de l'humidité ou de la corrosion et de plus, permettre un marquage adéquat (logo, caractères, image etc.)

Une variante non illustrée de la carte ou de l'étiquette, obtenue par le procédé selon l'invention, est constituée par l'assemblage sur un substrat, d'une couche adhésive et d'une couche conductrice sur chaque face du substrat. Le substrat comprend au moins une fenêtre dans laquelle est logé un composant électronique. Les couches adhésives maintiennent les couches conductrices sur chaque côté du substrat et au moins une couche conductrice s'étend partiellement dans la surface de la fenêtre de manière à former au moins un contact électrique. Les contacts du composant électronique sont connectés, soit au moyen d'un pont à au moins une des couches conductrices recouvrant le substrat, soit par connexion directe sur la surface de contact située dans la fenêtre du substrat.

L'épaisseur du substrat d'une carte fabriquée selon le procédé décrit par l'invention peut être comparable à la hauteur maximale d'un ou des composants électroniques même si ceux-ci ont une hauteur relativement élevée. Ceci est notamment le cas des composants tels que batteries ou des affichages. Une telle carte peut ainsi atteindre plusieurs millimètres d'épaisseur, en particulier si une grande rigidité est souhaitée.

## Revendications

1. Procédé de fabrication de cartes ou d'étiquettes électroniques réalisées par assemblage d'au moins un substrat (7) souple de faible épaisseur, une couche conductrice (4) et une couche adhésive (1), et comprenant au moins un composant électronique (11) comportant au moins un contact (10), ladite couche conductrice (4) étant constituée de pistes conductrices définissant une antenne, ledit procédé est **caractérisé en ce qu'**il comporte les étapes suivantes à effectuer par ordre chronologique :
- formation d'au moins une fenêtre (2) dans la couche adhésive (1),
- superposition et assemblage de la couche adhésive (1) sur la couche conductrice (4), obtention d'un ensemble (3) couche adhésive couche conductrice,
- formation d'au moins une ouverture formant au moins un segment (6) dans la fenêtre (2) de l'ensemble (3) couche adhésive couche conductrice, ledit segment (6), localisé dans la couche conductrice (4), permettant de préparer des surfaces de contact (4') séparées pour le composant électronique (11),
- formation d'au moins une fenêtre (8) dans le substrat (7), ladite fenêtre (8) étant destinée à recevoir le composant électronique (11),
- superposition et laminage de l'ensemble (3) couche adhésive couche conductrice sur le substrat (7) de façon à faire correspondre la fenêtre (8) du substrat (7) avec la fenêtre (2) de l'ensemble (3) couche adhésive couche conductrice formées précédemment,
- réalisation dans la couche conductrice (4) d'un circuit électrique formé d'une pluralité de pistes, les surfaces de contact (4') étant localisées dans la fenêtre (8) du substrat (7) destinée au composant électronique (11),
- mise en place du composant électronique (11) dans la fenêtre (8) du substrat (7) et connexion du contact (10) dudit composant électronique (11) à une des surfaces de contact (4') formées précédemment.

2. Procédé selon la revendication 1, **caractérisé en ce que** la couche adhésive (1) est constituée par un film de colle.

3. Procédé selon la revendication 1, **caractérisé en ce que** la fenêtre (2) de l'ensemble (3) couche adhésive couche conductrice est formée par dépôt d'une colle liquide sur la couche conductrice (4) par sérigraphie avec au moins une épargne pour la fenêtre (2).

4. Procédé selon la revendication 1, **caractérisé en ce que** la fenêtre (2) de la couche adhésive (1) est formée par dépôt d'une colle liquide sur le substrat (7) par sérigraphie avec au moins une épargne pour la fenêtre (2).

5. Procédé selon la revendication 1, **caractérisé en ce que** la réalisation du circuit électrique est effectuée par étampage, usinage ou gravure chimique de la couche conductrice (4).

6. Procédé selon la revendication 1, **caractérisé en ce que** la connexion du contact (10) dudit composant électronique (11) est effectuée par des moyens tels que le soudage, le collage conducteur, le thermo-collage avec film conducteur, ou la thermo-compression.

7. Procédé selon la revendication 1, **caractérisé en ce que** la formation de la fenêtre (2) dans la couche adhésive (1), de la fenêtre (8) dans le substrat (7), de l'ouverture formant le segment (6) dans la couche conductrice (4) est effectuée par étampage.

8. Procédé selon les revendications 1 à 7, **caractérisé en ce que** la couche conductrice (4) est disposée de sorte qu'elle s'étende partiellement dans la surface de la fenêtre (8) en formant au moins deux contacts électriques (4') sur lesquels est connecté le composant électronique (11),

9. Procédé selon les revendications 1 à 7, **caractérisé en ce que** la couche conductrice (4) est disposée de sorte qu'elle s'étende dans la surface de la fenêtre (8) en formant au moins un contact électrique (4') sur lequel est connecté le composant électronique (11), et un autre contact électrique étant formé au moyen d'un pont (12, 15) reliant une plage de connexion plus éloignée sur la couche conductrice (4).

10. Procédé selon les revendications 1 à 9, **caractérisé en ce que** l'épaisseur du substrat (7) est au moins égale à la hauteur du composant électronique (11) le plus haut.

11. Procédé selon les revendications 1 à 10, **caractérisé en ce qu'**une étape finale consiste à assembler un film de matière isolante sur chacune des faces de l'assemblage, ledit film servant de protection et/ou de support permettant un marquage.

## Patentansprüche

1. Herstellungsverfahren für elektronische Karten oder Etiketten durch Zusammenbau mindestens eines biegsamen Substrats (7) geringer Dicke, einer leitenden Schicht (4) und einer Klebschicht (1), mit mindestens einem elektronischen Bauelement (11) mit mindestens einem Kontakt (10), wobei die leitende Schicht (4) aus Leiterbahnen besteht, die eine Antenne definieren, wobei das Verfahren **dadurch gekennzeichnet ist, dass** es die folgenden Schritte umfasst, die in chronologischer Reihenfolge durchzuführen sind:
- Bildung mindestens eines Fensters (2) in der Klebschicht (1),
- Überlagerung und Zusammenbau der Klebschicht (1) mit der leitenden Schicht (4), Erhalt einer Einheit (3) Klebschicht-leitende Schicht,
- Bildung mindestens einer Öffnung, die mindestens ein Segment (6) in dem Fenster (2) der Einheit (3) Klebschicht-leitende Schicht bildet, wobei das Segment (6), in der leitenden Schicht (4) gelegen, es ermöglicht, getrennte Kontaktflächen (4') für das elektronische Bauelement (11) vorzubereiten,
- Bildung mindestens eines Fensters (8) in dem Substrat (7), wobei das Fenster (8) zur Aufnahme des elektronischen Bauelements (11) dient,
- Überlagerung und Schichtung der Einheit (3) Klebschicht-leitende Schicht auf dem Substrat (7), so dass das Fenster (8) des Substrats (7) dem Fenster (2) der vorher gebildeten Einheit (3) Klebschicht-leitende Schicht entspricht,
- in der leitenden Schicht (4) Herstellung eines aus einer Vielzahl von Leiterbahnen gebildeten Stromkreises, wobei die Kontaktflächen (4') in dem für das elektronische Bauelement (11) bestimmten Fenster (8) des Substrats (7) liegen,
- Platzierung des elektronischen Bauelements (11) in dem Fenster (8) des Substrats (7) und Verbindung des Kontakts (10) des elektronischen Bauelements (11) mit einer der vorher gebildeten Kontaktflächen (4').

2. Verfahren nach Anspruch 1, **gekennzeichnet dadurch, dass** die Klebschicht (1) aus einem Klebstofffilm besteht.

3. Verfahren nach Anspruch 1, **gekennzeichnet dadurch, dass** das Fenster (2) der Einheit (3) Klebschicht-leitende Schicht durch Auftragen eines flüssigen Klebstoffs auf die leitende Schicht (4) durch Siebdruck mit mindestens einer Aussparung für das Fenster (2) gebildet wird.

4. Verfahren nach Anspruch 1, **gekennzeichnet dadurch, dass** das Fenster (2) der Klebschicht (1) durch Auftragen eines flüssigen Klebstoffs auf das Substrat (7) durch Siebdruck mit mindestens einer Aussparung für das Fenster (2) gebildet wird.

5. Verfahren nach Anspruch 1, **gekennzeichnet dadurch, dass** der Stromkreis durch Stanzen, maschinelle Bearbeitung oder chemisches Ätzen der leitenden Schicht (4) hergestellt wird.

6. Verfahren nach Anspruch 1, **gekennzeichnet dadurch, dass** die Verbindung des Kontakts (10) des genannten elektronischen Bauelements (11) durch Mittel durchgeführt wird wie Schweißung, elektrisch leitendes Kleben, Thermo-Klebung mit leitfähigem Film oder Thermokompression.

7. Verfahren nach Anspruch 1, **gekennzeichnet dadurch, dass** die Bildung des Fensters (2) in der Klebschicht (1), des Fensters (8) in dem Substrat (7), der Öffnung, die das Segment (6) in der leitenden Schicht (4) bildet, durch Stanzen durchgeführt wird.

8. Verfahren nach den Ansprüchen 1 bis 7, **gekennzeichnet dadurch, dass** die leitende Schicht (4) derart angeordnet ist, dass sie sich teilweise in die Oberfläche des Fensters (8) erstreckt, wobei sie mindestens zwei elektrische Kontakte bildet (4'), auf denen das elektronische Bauelement (11) verbunden ist.

9. Verfahren nach den Ansprüchen 1 bis 7, **gekennzeichnet dadurch, dass** die leitende Schicht (4) derart angeordnet ist, dass sie sich in die Oberfläche des Fensters (8) erstreckt, wobei sie mindestens einen elektrische Kontakt (4') bildet, auf dem das elektronische Bauelement (11) verbunden ist, und einen anderen elektrischen Kontakt mittels einer Brücke (12, 15), die eine entferntere Anschlussfläche auf der leitenden Schicht (4) verbindet.

10. Verfahren nach den Ansprüchen 1 bis 9, **gekennzeichnet dadurch, dass** die Dicke des Substrats (7) mindestens gleich der Höhe des höchsten elektronischen Bauelements (11) ist.

11. Verfahren nach den Ansprüchen 1 bis 10, **gekennzeichnet dadurch, dass** eine Endphase darin besteht, einen Film aus Isoliermaterial auf jeder Seite der Einheit anzubringen, der als Schutz und/oder Stütze dient, wodurch eine Markierung möglich wird.

## Claims

1. Method for manufacturing cards or electronic labels carried out by assembling at least one thin, flexible substrate (7), a conductive layer (4) and an adhesive layer (1), and comprising at least one electronic component (11) including at least one contact (10), said conductive layer (4) being made up of conductive tracks defining an antenna, said method being **characterized in that** it includes the following steps to be carried out in a chronological order:
- forming of at least one window (2) in the adhesive layer (1),
- superimposing and assembling the adhesive layer (1) on the conductive layer (4), obtaining a set (3) adhesive layer and conductive layer,
- forming at least one opening forming at least one segment (6) in the window (2) of the set (3) adhesive layer and conductive layer, said segment (6), located in the conductive layer (4), allowing to prepare separated contact surfaces (4') for the electronic component (11),
- forming at least one window (8) in the substrate (7), said window (8) being intended to receive the electronic component (11),
- superimposing and laminating the set (3) adhesive layer and conductive layer on the substrate (7) in order to make correspond the window (8) of the substrate (7) with the window (2) of the set (3) adhesive layer and conductive layer previously formed,
- realizing in the conductive layer (4) an electric circuit formed by a plurality of tracks, the contact surfaces (4') being located in the window (8) of the substrate (7) intended to the electronic component (11),
- placing the electronic component (11) into the window (8) of the substrate (7) and connecting the contact (10) of said electronic component (11) with one of the contact surfaces (4') previously formed.

2. Method according to claim 1, **characterized in that** the adhesive layer (1) is made up of a film of glue.

3. Method according to claim 1, **characterized in that** the window (2) of the set (3) adhesive layer and conductive layer is formed by depositing a liquid glue on the conductive layer (4) by silk-screening with at least one protected area for the window (2).

4. Method according to claim 1, **characterized in that** the window (2) of the adhesive layer (1) is formed by depositing a liquid glue on the substrate (7) by silk-screening with at least one protected area for the window (2).

5. Method according to claim 1, **characterized in that** the realization of the electric circuit is carried out by stamping, machining or chemical etching of the conductive layer (4).

6. Method according to claim 1, **characterized in that** the connection of the contact (10) of said electronic component (11) is carried out by means such as soldering, conductive bonding, hot bonding with a conductive film, or thermo-compression.

7. Method according to claim 1, **characterized in that** the formation of the windows (2) in the adhesive layer (1), the window (8) in the substrate (7), the opening forming the segment (6) in the conductive layer (4) is carried out by stamping.

8. Method according to the claims 1 to 7, **characterized in that** the conductive layer (4) is deposited so as to extend partially into the surface of the window (8) by forming at least two electric contacts (4') on which the electronic component (11) is connected.

9. Method according to the claims 1 to 7, **characterized in that** the conductive layer (4) is deposited so as to extend into the surface of the window (8) by forming at least one electric contact (4') on which the electronic component (11) is connected, and another electric contact being formed by means of a bridge (12, 15) linking a more distant connection area on the conductive layer (4).

10. Method according to the claims 1 to 9, **characterized in that** the thickness of the substrate (7) is at least equal to the height of the highest electronic component (11).

11. Method according to the claims 1 to 10, **characterized in that** a final step consists in assembling a film of insulating material on each face of the assembly, said film serving as protection and/or support allowing a marking to be made.
